**Europäisches Patentamt**

**European Patent Office**

**Office européen des brevets**

(19)

(11) Veröffentlichungsnummer : **0 164 143**
**B1**

(12)

## EUROPÄISCHE PATENTSCHRIFT

(45) Veröffentlichungstag der Patentschrift :
07.09.88

(21) Anmeldenummer : 85200657.6

(22) Anmeldetag : 29.04.85

(51) Int. Cl.⁴ : **C 30 B 33/00**, C 30 B 29/28,
C 09 K 13/04

(54) Verfahren zum Ätzen von ferrimagnetischen Granatverbindungen.

(30) Priorität : 09.05.84 DE 3416991

(43) Veröffentlichungstag der Anmeldung :
11.12.85 Patentblatt 85/50

(45) Bekanntmachung des Hinweises auf die Patenterteilung : 07.09.88 Patentblatt 88/36

(84) Benannte Vertragsstaaten :
CH DE FR GB LI

(56) Entgegenhaltungen :
US-A- 3 755 023
US-A- 3 808 068
Ullmanns Encyklopädie der technischen Chemie,
1976, Band 12, Seite 166

(73) Patentinhaber : Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
CH FR GB LI

(72) Erfinder : Klages, Claus-Peter, Dr.
Kanalstrasse 18
D-2000 Hamburg 76 (DE)

(74) Vertreter : Nehmzow-David, Fritzi-Maria et al
Philips Patentverwaltung GmbH Wendenstrasse 35
Postfach 10 51 49
D-2000 Hamburg 1 (DE)

## Beschreibung

Die Erfindung bezieht sich auf ein Verfahren zum Ätzen von ferrimagnetischen Granatverbindungen unter Verwendung einer, mindestens eine starke Mineralsäure enthaltenden Ätzlösung.

Ferrimagnetische Granatverbindungen in Form von Einkristallscheiben oder -Schichten haben zunehmend Bedeutung erlangt in der Fertigung von z. B. Mikrowellen-, Blasendomänen- oder magnetooptischen Anordnungen. In allen diesen Anwendungen ist es erforderlich, daß Granateinkristallflächen poliergeätzt werden und/oder daß die Einkristallfläche in bestimmten Bereichen photolithographisch strukturiert wird ; dabei sind von besonderem Interesse epitaktisch erzeugte ferrimagnetische Einkristallschichten auf nichtmagnetischen Substraten.

Als Granatmaterial werden für diese Zwecke $A_3B_5O_{12}$-Verbindungen eingesetzt, in denen A) Seltenerdmetalle, Yttrium, Wismut oder Mischungen davon und B) Eisen, Aluminium, Gallium, Scandium, Platin oder Mischungen davon sind. Die Ätzrate dieser Materialien ist dabei abhängig von der Temperatur und der Zusammensetzung der Ätzlösung.

Aus US-PS 3 808 068 ist ein Verfahren zum Ätzen von ferrimagnetischen Granatverbindungen bekannt, bei dem das Granatgitter in den zu ätzenden Bereichen zunächst durch Ionenimplantation gestört wird und die Ätzung dann mit Standardätzmitteln, z. B. $H_3PO_4$ oder HCl, bei einer Temperatur von etwa 160 °C vorgenommen wird. Ätztemperaturen in dem genannten Temperaturbereich stellen einmal eine thermische Belastung der zu ätzenden Granatkörper dar, zum anderen ist die Maßnahme einer Ionenimplantation zur Erhöhung der Ätzrate für großtechnische Prozesse wenig geeignet, da sie nur unter großem apparativen Aufwand realisierbar ist.

Der Erfindung liegt die Aufgabe zugrunde, ein Verfahren zum Ätzen von ferrimagnetischen Granatverbindungen anzugeben, mit dem ein Ätzen unter geringer thermischer Belastung bei sehr geringem technischen Aufwand ermöglicht wird.

Diese Aufgabe wird erfindungsgemäß dadurch gelöst, daß die Ätzlösung zusätzlich ein Reduktionsmittel enthält.

Als Reduktionsmittel enthält die Ätzlösung vorzugsweise Ein- oder Zweielektronendonatoren vorteilhafterweise in einer Konzentration von 0,07 bis 0,6 Mol/l in Form von $Fe^{2+}$, $Ti^{3+}$, $V^{2+}$, $Sn^{2+}$.

Nach vorteilhaften Weiterbildungen der Erfindung enthält die Ätzlösung als Mineralsäure Phosphorsäure $H_3PO_4$ oder eine Mischung aus Phosphorsäure mit 10-prozentiger Salzsäure HCl im Volumenverhältnis 2 : 1.

Die mit der Erfindung erzielbaren Vorteile bestehen insbesondere in folgendem :

Die durch den Zusatz eines Reduktionsmittels zur Ätzlösung erreichbare absolute Erhöhung der Ätzgeschwindigkeit bei gegebener Temperatur erlaubt ein schnelleres Abätzen oder Strukturieren von Eisengranatschichten, was von besonderer Bedeutung ist bei dicken Epitaxieschichten (10 bis 100 μm) und bei Materialien mit geringer Ätzrate.

Durch die erreichte Absenkung der Ätztemperatur kann bei gleicher Ätzrate die thermische Belastung der zu ätzenden Granatkörper und damit z. B. die Bruchgefahr von Einkristallscheiben sehr verringert werden.

Da nur ferrimagnetische Granatverbindungen durch die erfindungsgemäße Ätzlösung beschleunigt, also mit größerer Ätzrate, geätzt werden, erfolgt nahezu kein Angriff der Ätzlösung auf z. B. nichtmagnetische Granatsubstrate, z. B. aus Gallium- oder Aluminiumgranat.

Dadurch wird die Rückseite einer nur einseitig mit einer ferrimagnetischen Granatschicht versehenen Substrateinkristallscheibe nahezu nicht angegriffen. Auf diese Weise kann selektiv geätzt werden, es kann z. B. ein nichtmagnetisches Substrat von einer defekten oder aus anderen Gründen nicht brauchbaren ferrimagnetischen Epitaxieschicht befreit werden und das abgeätzte Substrat kann dann erneut beschichtet werden.

Ein weiterer, mit der Verwendung der efindungsgemäßen Ätzlösung verbundener Vorteil ist, daß photolithographische Strukturierungsprozesse einfacher und besser durchführbar sind, da die chemische und thermische Beanspruchung einer Photolackmaske bei den möglichen relativ niedrigen Ätztemperaturen verringert wird. Es erübrigt sich dabei z. B., besondere Masken, z. B. aus Oxiden, die bei hohen Ätztemperaturen wegen ihrer besseren Beständigkeit gegenüber der Ätzlösung sonst erforderlich sind, einzusetzen.

Da das Ausmaß, in welchem der Ätzprozeß durch Zusatz von Reduktionsmitteln beschleunigt wird, von der kristallographischen Richtung der zu ätzenden Einkristallscheiben oder -Schichten abhängt, kann die Anisotropie des Ätzvorganges beeinflußt werden, es können also z. B. Ätzflanken beeinflußt werden.

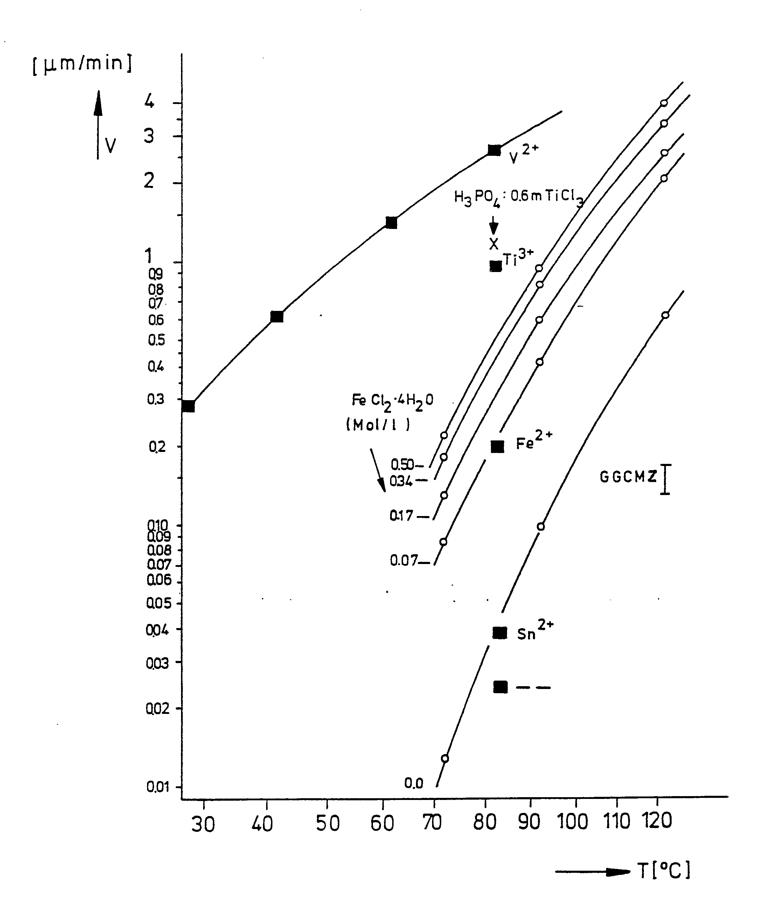

Anhand der Zeichnung werden Ausführungsbeispiele der Erfindung beschrieben und in ihrer Wirkungsweise erläutert.

Die Figur zeigt Ätzraten von (111)-Granatschichten in starken Mineralsäuren mit und ohne Zusatz von Reduktionsmitteln.

Wie aus der Figur ersichtlich, wurden Ätzungen im Temperaturbereich von 25 bis 120 °C ausgeführt. Als Eisengranatmaterial wurden Proben von Epitaxieschichten einer Dicke von 5 bis 6 μm einer Zusammensetzung von $(Gd,Bi,Pb)_3(Fe,Al,Ga,Pt)_5O_{12}$ untersucht. Die Epitaxieschichten waren auf

2

Substraten der Zusammensetzung (Gd,Ca)$_3$(Ga,Mg,Zr)$_5$O$_{12}$ (GGCMZ) angebracht. Zur Bestimmung der Ätzraten wurden Proben von etwa 3 bis 5 mm Kantenlänge in Reagenzgläsern unter kräftigem magnetischem Rühren (300 bis 500 U/min) mit den nachfolgend aufgeführten Ätzlösungen geätzt, wobei die Zeit bis zum Verschwinden der Schicht gemessen wurde.

Außerdem wurden Proben von Epitaxieschichten einer Zusammensetzung von Y$_3$Fe$_5$O$_{12}$ untersucht.

Als Ätzlösung wurden Phosphorsäure (85-prozentige wässerige Lösung) und Gemische im Volumenverhältnis 2 : 1 von Phosphorsäure H$_3$PO$_4$ mit 10-prozentiger Salzsäure HCl eingesetzt, denen 0 und 0,6 Mol/l einer Verbindung der reduzierenden Ionen Fe$^{2+}$, Ti$^{3+}$, V$^{2+}$ und Sn$^{2+}$ zugesetzt wurden, wobei von folgenden Verbindungen ausgegangen wurde :

Fe$^{2+}$ : FeCl$_2$·4H$_2$O.

Ti$^{3+}$ : 15-prozentige Lösung in 10-prozentiger HCl.

V$^{2+}$ : VOSO$_4$·5H$_2$O, reduziert in 10-prozentiger HCl mit Zinkperlen.

Sn$^{2+}$ : SnCl$_2$·2H$_2$O.

In der Figur sind die verwendeten Ätzlösung wie folgt dargestellt :

O = H$_3$PO$_4$ in Form der 85-prozentigen wässerigen Lösung mit Zusätzen von FeCl$_2$·4H$_2$O in Konzentrationen von 0,07 bis 0,5 Mol/l.

■ = H$_3$PO$_4$ + 10-prozentige HCl im Volumenverhältnis 2 : 1 mit Zusätzen von jeweils 0,33 Mol/l des Reduktionsmittels und ohne Zusatz von Reduktionsmittel.

X = H$_3$PO$_4$ mit Zusatz von 0,6 Mol/l TiCl$_3$.

Der mit GGCMZ gekennzeichnete Balken in der Figur zeigt die Ätzgeschwindigkeit eines nichtmagnetischen Granatsubstrats der Zusammensetzung (Gd,Ca)$_3$(Ga,Mg,Zr)$_5$O$_{12}$.

Wie aus der Figur ersichtlich, wird ein Ätzprozeß an ferrimagnetischen Granatschichten in Gegenwart von Fe$^{2+}$-Ionen erheblich beschleunigt gegenüber einem Ätzprozeß ohne Reduktionsmittelzusatz ; bei 70° liegt eine Ätzbeschleunigung um einen Faktor 20 vor, bei 120 °C ist die Ätzbeschleunigung immer noch um einen Faktor 7 größer. Die Temperaturabhängigkeit der Ätzgeschwindigkeit wird durch einen Fe$^{2+}$-Zusatz offenbar etwas verringert, wobei sie bei konstanter Temperatur nicht linear mit der Fe$^{2+}$-Konzentration zunimmt sonern sich einem konstanten Wert zu nähern scheint, der vermutlich durch die Geschwindigkeit einer vorgeschalteten oder nachfolgenden Reaktion bestimmt wird.

Noch stärker wirksam als Fe$^{2+}$-Zusätze zeigen sich Ti$^{3+}$- und V$^{2+}$-Zusätze, während ein Sn$^{2+}$-Zusatz nur eine leichte Steigerung der Ätzgeschwindigkeit gegenüber Ätzlösungen ohne Reduktionsmittelzusatz zeigt. In Gegenwart von V$^{2+}$ ist die Ätzgeschwindigkeit um rund 2 Größenordnungen größer als bei Ätzlösungen ohne Reduktionmittelzusatz.

Die Erhöhung der Ätzgeschwindigkeit durch einen Reduktionsmittelzusatz macht es damit möglich, einen Ätzprozeß schon bei Raumtemperatur in annehmbaren Zeiten durchzuführen.

Die Lösungsgeschwindigkeit von Nichteisengranaten in starken Mineralsäuren wird durch den Zusatz von Reduktionsmitteln nicht vergrößert : die relative Gewichtsabnahme pro Zeiteinheit von nichtmagnetischen GGCMZ-Substratscheiben in (111)-Orientierung ist praktisch unabhängig von der Konzentration an Fe$^{2+}$ in H$_3$PO$_4$ ; die Ätzgeschwindigkeit beträgt hier bei 120 °C etwa, $2,5 \cdot 10^{-7}$ cm/s, wobei Versuche in H$_3$PO$_4$ ohne und mit Fe$^{2+}$-Zusatz in Konzentrationen bis zu 0,34 Mol/l ausgeführt wurden (vergleiche mit GGCMZ gekennzeichneter senkrechter Balken in der Figur).

Ätzraten von epitaxialen (111)-Granatschichten in starken Mineralsäuren mit und ohne Reduktionsmittelzusatz sind in der nachfolgenden Tabelle dargestellt, wobei neben Beispielen für ferrimagnetische Granatschichten am Schluß der Tabelle auch zwei Beispiele für das Ätzen von Nichteisengranatsubstraten aufgeführt sind :

(Siehe Tabellen Seite 4 ff.)

Ätzraten von (111)-Granatschichten in starken Mineralsäuren mit und ohne Zusatz von Reduktions-mittel :

| ÄTZLÖSUNG | KONZENTRATION DES REDUKTIONS-MITTELS $[Mol/l]$ | ZUSAMMENSETZUNG DES GEÄTZTEN GRANATS | ÄTZTEMPERATUR $[^{\circ}C]$ | ÄTZGESCHWINDIG-KEIT $[\mu m/min]$ |
|---|---|---|---|---|
| $H_3PO_4(85\%)$ :$Fe^{2+}$ | – | $(Gd,Bi,Pb)_3(Fe,Al,Ga,Pt)_5O_{12}$ | 70 | 0,013 |
| –"– | 0,07 | –"– | –"– | 0,087 |
| –"– | 0,17 | –"– | –"– | 0,130 |
| –"– | 0,34 | –"– | –"– | 0,18 |
| –"– | 0,50 | –"– | –"– | 0,22 |
| –"– | – | –"– | 90 | 0,09 |
| –"– | 0,07 | –"– | –"– | 0,42 |
| –"– | 0,17 | –"– | –"– | 0,60 |
| –"– | 0,34 | –"– | –"– | 0,87 |
| –"– | 0,50 | –"– | –"– | 0,96 |
| –"– | – | –"– | 120 | 0,63 |
| –"– | 0,07 | –"– | –"– | 2,06 |

0 164 143

**Tabelle (Fortsetzung)**

| ÄTZLÖSUNG | KONZENTRATION DES REDUKTIONS-MITTELS $[\text{Mol/l}]$ | ZUSAMMENSETZUNG DES GEÄTZTEN GRANATS | ÄTZTEMPERATUR $[°\text{C}]$ | ÄTZGESCHWINDIG-KEIT $[\text{um/min}]$ |
|---|---|---|---|---|
| $H_3PO_4(85\%)$ :$Fe^{2+}$ | 0,17 | $(Gd,Bi,Pb)_3(Fe,Al,Ga,Pt)_5O_{12}$ | 120 | 2,59 |
| $-"-$ | 0,34 | $-"-$ | $-"-$ | 3,40 |
| $-"-$ | 0,50 | $-"-$ | $-"-$ | 4,01 |
| $H_3PO_4(85\%)+$ HCl $(10\%)$ $(2:1)$ :$V^{2+}$ | 0,33 | $-"-$ | 25 | 0,29 |
| $-"-$ | 0,33 | $-"-$ | 40 | 0,63 |
| $-"-$ | 0,33 | $-"-$ | 60 | 1,41 |
| $-"-$ | 0,33 | $-"-$ | 80 | 2,70 |

0 164 143

Tabelle (Fortsetzung)

| ÄTZLÖSUNG | KONZENTRATION DES REDUKTIONSMITTELS $[\text{Mol/1}]$ | ZUSAMMENSETZUNG DES GEÄTZTEN GRANATS | ÄTZTEMPERATUR $[^\circ C]$ | ÄTZGESCHWINDIG-KEIT $[\text{um/min}]$ |
|---|---|---|---|---|
| $H_3PO_4$ (85%) + HCl (10%) (2:1) : $Ti^{3+}$ | 0,33 | $(Gd,Bi,Pb)_3(Fe,Al,Ga,Pt)_5O_{12}$ | 70 | 0,96 |
| $H_3PO_4$ (85%) + HCl (10%) (2:1) : $Fe^{2+}$ | 0,33 | –"– | 80 | 0,20 |
| $H_3PO_4$ (85%) + HCl (10%) (2:1) : $Sn^{2+}$ | 0,33 | –"– | 80 | 0,04 |
| $H_3PO_4$ (85%) : $Ti^{3+}$ | 0,6 | –"– | 80 | 1,2 |
| $H_3PO_4$ (85%) + HCl (10%) (2:1) | – | $(Gd,Ca)_3(Ga,Mg,Zr)_5O_{12}$ | 120 | 0,15 ± 0,02 |
| $H_3PO_4$ (85%) + HCl (10%) (2:1) : $Fe^{2+}$ | 0,34 | –"– | 120 | |

0 164 143

**Patentansprüche**

1. Verfahren zum Ätzen von ferrimagnetischen Granatverbindungen unter Verwendung einer, mindestens eine starke Mineralsäure enthalenden Ätzlösung, dadurch gekennzeichnet, daß die Ätzlösung zusätzlich ein Reduktionsmittel enthält.

2. Verfahren nach Anspruch 1, dadurch gekennzeichnet, daß die Ätzlösung als Mineralsäure Phosphorsäure $H_3PO_4$ enthält.

3. Verfahren nach Anspruch 1, dadurch gekennzeichnet, daß die Ätzlösung als Mineralsäure $H_3PO_4$ in Form ihrer 85-prozentigen wässerigen Lösung und 10-prozentige Salzsäure HCl in einem Volumenverhältnis von 2 : 1 enthält.

4. Verfahren nach einem der vorhergehenden Ansprüche, dadurch gekennzeichnet, daß die Ätzlösung als Reduktionsmittel Ein- oder Zweielektronendonatoren enthält.

5. Verfahren nach Anspruch 4, dadurch gekennzeichnet, daß die Ätzlösung Ein- oder Zweielektronendonatoren in einer Konzentration von 0,07 bis 0,6 Mol/l enthält.

6. Verfahren nach den Ansprüchen 4 und 5, dadurch gekennzeichnet, daß die Ätzlösung als Reduktionsmittel $Fe^{2+}$, $Ti^{3+}$, $V^{2+}$ und/oder $Sn^{2+}$ enthält.

7. Verfahren nach den Ansprüchen 1 bis 6, dadurch gekennzeichnet, daß bei einer Ätztemperatur im Bereich von 20 bis 120 °C geätzt wird.

**Claims**

1. A method of etching ferrimagnetic garnet compounds, in which use is made of an etching solution which comprises at least one strong mineral aid, characterized in that it comprises additionally a reducing agent.

2. A method as claimed in Claim 1, characterized in that the etching solution comprises phosphoric acid $H_3PO_4$ as a mineral acid.

3. A method as claimed in Claim 1, characterized in that the etching solution comprises as a mineral acid $H_3PO_4$ in the form of its 85 % aqueous solution and 10 % hydrochloric acid HCl in a volume ratio of 2 : 1.

4. A method as claimed in one of the preceding Claims, characterized in that the etching solution comprises one- or two-electron donors as a reducing agent.

5. A method as claimed in Claim 4, characterized in that the etching solution comprises one- or two-electron donors in a concentration form 0.07 to 0.6 mol/l.

6. A method as claimed in Claims 4 and 5, characterized in that the etching solution comprises $Fe^{2+}$, $Ti^{3+}$, $V^{2+}$ and/or $Sn^{2+}$ as reducing agents.

7. A method as claimed in Claims 1 to 6, characterized in that etching is carried out at an etching temperature in the range from 20 to 120 °C.

**Revendications**

1. Procédé pour le décapage de composés ferrimagnétiques de grenats à l'aide d'une solution de décapage contenant au moins un acide minéral fort, caractérisé en ce que la solution de décapage contient en outre un agent de réduction.

2. Procédé selon la revendication 1, caractérisé en ce que la solution de décapage contient de l'acide phosphorique $H_3PO_4$ comme acide minéral.

3. Procédé selon la revendication 1, caractérisé en ce que comme acide minéral la solution de décapage contient $H_3PO_4$ sous forme de sa solution aqueuse à 85 % et de l'acide chlorhydrique HCl à 10 % dans un rapport en volume de 2 : 1.

4. Procédé selon l'une des revendications précédentes, caractérisé en ce que comme agent de réduction, la solution de décapage contient un donneur à 1 ou 2 électrons.

5. Procédé selon la revendication 4, caractérisé en ce que la solution de décapage contient des donneurs à un ou à deux électrons dans une concentration de 0,07 et 0,6 mole/l.

6. Procédé selon l'une des revendications 4 et 5, caractérisé en ce que comme agent de réduction, la solution de décapage contient $Fe^{2+}$, $Ti^{3+}$, $V^{2+}$ et/ou $Sn^{2+}$.

7. Procédé selon les revendications 1 à 6, caractérisé en ce que le décapage s'effectue à une température située dans la gamme comprise entre 20 et 120 °C.

0 164 143